# EUROPÄISCHE PATENTSCHRIFT

(11) **EP 0 940 066 B1**
(45) Veröffentlichungstag und Bekanntmachung des Hinweises auf die Patenterteilung: **11.10.2000**
(21) Anmeldenummer: 97951793.5
(22) Anmeldetag: 20.11.1997
(51) Int. Cl.: H05K 7/10

(54) **EINRICHTUNG ZUR CODIERUNG VON STECKBAUGRUPPEN SOWIE EINRICHTUNG ZUM ANSCHLUSS EXTERNER LEITUNGEN MIT EINER DERARTIGEN CODIEREINRICHTUNG**
DEVICE FOR CODING PLUG-IN MODULES AND DEVICE FOR CONNECTING EXTERNAL LINES BY MEANS OF SUCH A CODING DEVICE
DISPOSITIF DE CODAGE D'UNITES ENFICHABLES ET DISPOSITIF DE CONNEXION DE LIGNES EXTERIEURES AU MOYEN D'UN TEL DISPOSITIF DE CODAGE

(30) Priorität: 22.11.1996 DE 29620407 U
(43) Veröffentlichungstag der Anmeldung: 08.09.1999
(73) Patentinhaber: SIEMENS AKTIENGESELLSCHAFT, 80333 München (DE)
(72) Erfinder: BALZER, Kurt, D-76767 Hagenbach (DE); MORLOCK, Siegfried, D-75196 Remchingen (DE)
(86) Internationale Anmeldenummer: DE9702726
(87) Internationale Veröffentlichungsnummer: WO9824282

(56) Entgegenhaltungen:
- EP-A- 0 113 795
- EP-A- 0 392 629
- CH-A- 607 542
- DE-A- 4 323 440
- US-A- 4 401 358

## Beschreibung

Die Erfindung betrifft eine Einrichtung zur Codierung von Steckbaugruppen nach dem Oberbegriff des Anspruchs 1 sowie eine Einrichtung zum Anschluß externer Leitungen mit einer derartigen Codiereinrichtung nach dem Oberbegriff des Anspruchs 3.

Aus der DE 43 23 440 A1 ist eine Einrichtung zum Anschluß externer Leitungen an eine speicherprogrammierbare Steuerung bekannt, die zur Signalübertragung mit dieser gekoppelt und räumlich unabhängig von der speicherprogrammierbaren Steuerung aufstellbar ist. Die Anschlußeinrichtung erlaubt einen modularen Aufbau, bei dem je Aktor-/Sensoranschluß eine Anschlußstelle vorhanden ist, die dem jeweiligen Anschlußtyp entsprechend mit einem elektronischen Modul zur Signalanpassung und -umsetzung versehen werden kann. Ein- und Ausgabemodule sind dabei beliebig mischbar. Dies wirkt sich vorteilhaft auf die Projektierung, Montage, Fehlerbeseitigung oder Erweiterung des elektronischen Geräts aus. Die Anschlußeinrichtung fungiert gleichzeitig als Trägereinheit für die elektronischen Module, die als Steckbaugruppen ausgeführt sind, und weist eine Vielzahl gleichartiger, äquidistant nebeneinander angeordneter Steckplätze für diese auf. Versorgungs- und Signalleitungen werden den elektronischen Modulen jeweils über einen Steckverbinder am Steckplatz zugeführt. Jedes elektronische Modul enthält eine Signalanpassungsschaltung für auf den externen Leitungen geführte Signale eines Signalkanals. Anschlußelemente zum Anschluß externer Leitungen sind im selben Rasterabstand wie die Steckplätze angebracht und diesen zugeordnet.

Der Erfindung liegt die Aufgabe zugrunde, eine Einrichtung zur Codierung von Steckbaugruppen zu schaffen, durch die verhindert werden kann, daß in äquidistant nebeneinander angeordneten Steckplätzen bei zwei Typen von Steckbaugruppen, die jeweils neben Steckbaugruppen des gleichen Typs beliebig steckbar sind, auf der einen Seite einer Steckbaugruppe des einen Typs eine Steckbaugruppe des anderen Typs in einen unmittelbar danebenliegenden Steckplatz einsteckbar ist. Eine zweite Aufgabe ist es, eine Einrichtung zum Anschluß externer Leitungen zu schaffen, mit der eine höhere Packungsdichte bei gleichzeitiger Einhaltung der Anforderungen an die Mindestkriechstrecke erreicht wird.

Zur Lösung der ersten Aufgabe weist die neue Einrichtung zur Codierung von Steckbaugruppen der eingangs genannten Art die im kennzeichnenden Teil des Anspruchs 1 angegebenen Merkmale auf. In Anspruch 2 ist eine vorteilhafte Weiterbildung dieser Einrichtung beschrieben. Eine neue Einrichtung zum Anschluß externer Leitungen ist zur Lösung der zweiten Aufgabe mit den in Anspruch 3 genannten Merkmalen versehen.

Die Erfindung hat den Vorteil, daß bei einer Verwendung von elektronischen Modulen mit niedriger Betriebsspannung die Packungsdichte auf das Zweifache erhöht wird. Gleichzeitig sind elektronische Module niedriger Betriebsspannung in einer Trägereinheit mit elektronischen Modulen einer höheren Betriebsspannung weiterhin mischbar, wobei in jedem Fall die Einhaltung der geforderten Mindestkriechstrecke gewährleistet ist. Durch die neue Einrichtung zur Codierung von Steckbaugruppen wird dazu eine bestimmte Bestückfolge zwingend vorgegeben, die vom Anwender nicht durchbrochen werden kann. Dies führt zu einer wesentlichen Erhöhung der Fehlersicherheit.

Anhand der Zeichnungen, in denen ein Ausführungsbeispiel der Erfindung dargestellt ist, werden im folgenden die Erfindung sowie Ausgestaltungen und Vorteile näher erläutert.

Es zeigen:
- Figur 1: eine Trägereinheit einer Einrichtung zum Anschluß externer Leitungen,
- Figur 2: eine Perspektivansicht einer uncodierten Steckbaugruppe,
- Figur 3: eine Seitenansicht der uncodierten Steckbaugruppe nach Figur 2,
- Figur 4: eine Perspektivansicht einer codierten Steckbaugruppe und
- Figur 5: eine Seitenansicht der codierten Steckbaugruppe nach Figur 4.

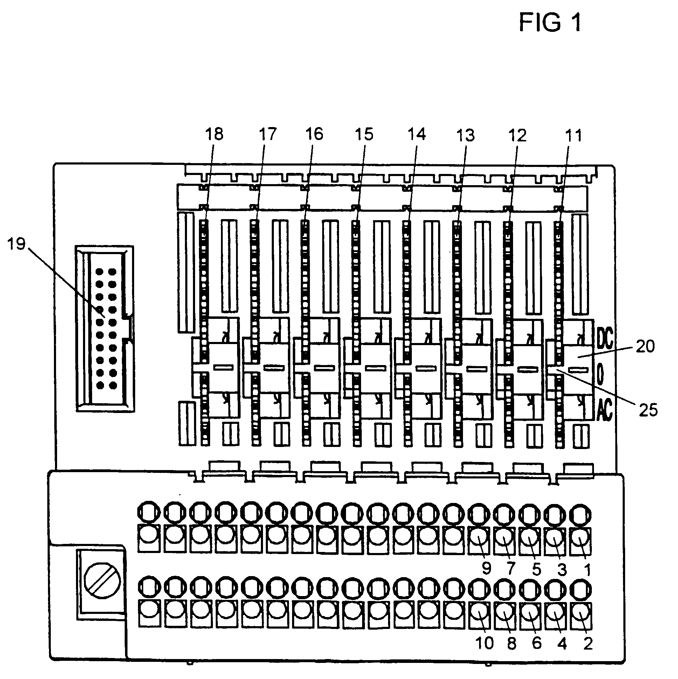

Bei der in Figur 1 dargestellten Trägereinheit handelt es sich um eine Einrichtung zum Anschluß externer Leitungen an ein Automatisierungsgerät. Die externen Leitungen, die beispielsweise zu Sensoren oder Aktoren an einem zu regelnden Prozeß führen, werden im unteren Teil des elektronischen Geräts beispielsweise an Anschlußelemente 1 ... 10 angeschlossen, die als Klemmen mit darüberliegenden Betätigungsöffnungen ausgeführt sind. Im oberen Teil des Geräts sind Steckplätze 11 ... 18 für elektronische Module angeordnet, die eine Signalanpassungsschaltung enthalten und eine Signalvorverarbeitung durchführen, die je nach Typ der externen Leitung unterschiedlich sein kann. Die Datenübertragung zum Automatisierungsgerät schließlich erfolgt über eine digitale Schnittstelle 19, in welcher je Kanal ein digitales Signal vorgesehen ist. Für einen Signalkanal werden jeweils zwei Anschlußklemmen benötigt, die übereinander angeordnet sind. Mit einem elektronischen Modul mit 24 V Gleichspannungsversorgung können zwei Signalkanäle bedient werden. Wird beispielsweise ein 24-V-Modul in den Steckplatz 11 eingesteckt, so wird ein Schieber 20 auf die Stellung "DC" gestellt und es können externe Leitungen für 24-V-Sensoren oder -Aktoren an einen ersten Signalkanal mit den Anschlußklemmen 1 und 2 sowie an einen zweiten Signalkanal mit den Anschlußklemmen 3 und 4 angeschlossen werden. Bei elektronischen Modulen mit 230 V Wechselspannungsversorgung wird nur ein Signalkanal bedient, der hier auf das rechte Anschlußklemmenpaar geführt ist. Für den Steckplatz 11 sind dies die Anschlußklemmen 1 und 2. Der Schieber 20 ist bei einer Bestückung mit einem 230-V-Modul auf die Stellung "AC" umzulegen. Für Leitungen, die an ein 230-V-Modul angeschlossen werden, wird gefordert, daß die Mindestkriechstrecke größer als 5,5 mm ist. Um diese Forderung einzuhalten, muß sichergestellt werden, daß die zu den Anschlußklemmen des Signalkanals eines AC-Moduls benachbarten Anschlußklemmen unbelegt bleiben. Wird beispielsweise in den Steckplatz 12 ein 230-V-Modul eingesetzt, so dienen die Anschlußklemmen 5 und 6 zur Verdrahtung seines Signalkanals. Die Anschlußklemmen 7 und 8 bleiben, da sie für das Modul am Steckplatz 12 vorgesehen sind, das aber bei dieser Bestückung keinen zweiten Signalkanal aufweist, automatisch unbelegt. Es muß aber dafür gesorgt werden, daß auch die Anschlußklemmen 3 und 4 frei bleiben. Unmittelbar rechts neben einem 230-V-Modul darf also kein 24-V-Modul gesteckt werden, das für zwei Signalkanäle ausgelegt ist, wohl aber ein einkanaliges 230-V-Modul. Dies wird durch eine Codierung am Gehäuse der elektronischen Module, die auch als Steckbaugruppen bezeichnet werden, verhindert. Der Steckplatz 13 kann, da ja die Klemmen 7 und 8 unbelegt sind, beliebig bestückt werden.

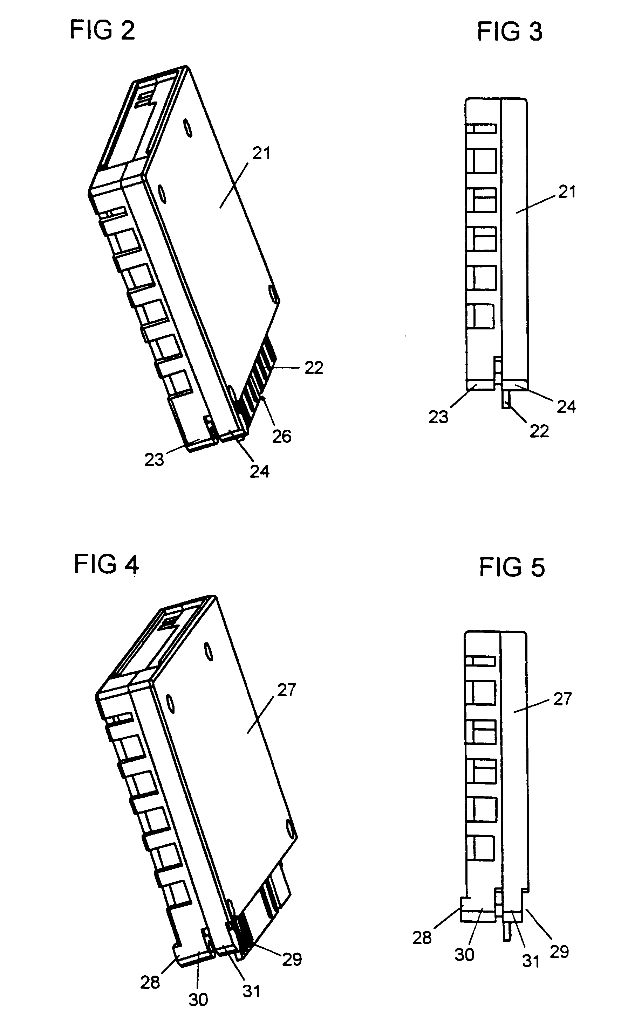

Die Figuren 2 und 3 zeigen eine uncodierte Steckbaugruppe in perspektivischer Ansicht bzw. Seitenansicht. Für gleiche Teile werden gleiche Bezugszeichen verwendet. Ihr Gehäuse 21 erstreckt sich im wesentlichen über die Breite eines Steckplatzrasters, das 10,16 mm beträgt. In dem Gehäuse 21 ist eine bestückte Leiterplatte 22 untergebracht, die das Gehäuse 21 an der Seite, mit der es in Einführschlitze der Trägereinheit eingesetzt wird, seitlich überragt. Zum Einsetzen in die in Figur 1 gezeigte Trägereinheit werden die Baugruppen mit Gelenkzapfen 23 und 24 an der Oberkante der Trägereinheit eingehängt und nach unten geschwenkt, so daß die Seitenkanten der Leiterplatte 22 mit auf ihrer Oberseite befindlichen Kontaktflächen eine Steckverbindung mit Kontaktfedern in den Einführschlitzen herstellen. Damit ein elektronisches Modul für Gleichspannungsversorgung nur in einem entsprechend verdrahteten Steckplatz eingesetzt werden kann, ist die Seitenkante mit einer zur Position eines Zapfens 25 (Figur 1) in der Stellung "DC" des Codierschiebers 20 korrespondierenden Ausnehmung 26 versehen. Uncodierte Baugruppen gemäß den Figuren 2 und 3 werden für elektronische Module mit 24 V Gleichspannungsversorgung verwendet und können in den Steckplätzen 11 ... 18 (Figur 1) beliebig nebeneinandergesteckt werden.

Das Gehäuse 27 einer codierten Baugruppe, wie sie in den Figuren 4 und 5 dargestellt ist, weist zur Codierung einen Fortsatz 28 auf der einen Seite und eine zu einem entsprechenden Fortsatz einer benachbarten codierten Steckbaugruppe korrespondierende Ausnehmung 29 auf der anderen Seite auf, so daß codierte Baugruppen ebenfalls beliebig nebeneinander in die Steckplätze 11 ... 18 einsteckbar sind. Die Codierung ist als Veränderung der Breite von Gelenkzapfen 30 und 31 ausgeführt, so daß bereits ein Einsetzen einer uncodierten Baugruppe unmittelbar auf der rechten Seite einer codierten Baugruppe in das Drehgelenk verhindert wird. Dadurch werden auf die Codierzapfen wirkende Kräfte gering gehalten und eine Beschädigung der Trägereinheit wie auch der Steckbaugruppen durch die Codierung praktisch ausgeschlossen. In unmittelbarer Nachbarschaft zu einer codierten Baugruppe kann somit auf der rechten Seite nur eine weitere codierte, auf der linken Seite dagegen wahlweise eine uncodierte oder eine codierte Steckbaugruppe eingesetzt werden. In einer Einrichtung zum Anschluß externer Leitungen wird somit durch die Codierung zuverlässig sichergestellt, daß die geforderte Mindestkriechstrecke für 230-V-Module eingehalten wird. Obwohl in dem Ausführungsbeispiel die Erfindung anhand einer Einrichtung zum Anschluß externer Leitungen als Trägereinheit und Umsetzmodulen als elektronische Module für die Steckplätze der Trägereinheit beschrieben wurde, ist die Erfindung auch bei beliebigen anderen Trägereinheiten zur Codierung von Steckbaugruppen geeignet. Beispielsweise kann sie zur Codierung von Steckbaugruppen in einem Baugruppenträger oder von Frontsteckern an einer mit Ein- oder Ausgabebaugruppen bestückten speicherprogrammierbaren Steuerung verwendet werden.

## Patentansprüche

1. Einrichtung zur Codierung von Steckbaugruppen, die für eine Bestückung in einer Trägereinheit mit äquidistant nebeneinander angeordneten Steckplätzen vorgesehen sind,
**dadurch gekennzeichnet,**
- daß codierte Steckbaugruppen einen Fortsatz (28) auf der einen Seite und eine zu einem entsprechenden Fortsatz einer benachbarten codierten Steckbaugruppe korrespondierende Ausnehmung (29) auf der anderen Seite aufweisen, so daß sie beliebig nebeneinander in die Steckplätze (11 ... 18) einsteckbar sind, und
- daß uncodierte Steckbaugruppen keine derartige Ausnehmung aufweisen, so daß sie auf der einen Seite einer codierten Steckbaugruppe nicht in einen unmittelbar danebenliegenden Steckplatz einsteckbar sind.

2. Einrichtung nach Anspruch 1, **dadurch gekennzeichnet,**
- daß die Baugruppen zum Einstecken an den Steckplätzen (11 ... 18) um ein Drehgelenk schwenkbar sind und
- daß sich Fortsatz (28) und Ausnehmung (29) codierter Steckbaugruppen im Bereich des Drehgelenks befinden, so daß durch einen Fortsatz gegebenenfalls bereits das Einsetzen einer uncodierten Steckbaugruppe in das Drehgelenk verhindert wird.

3. Einrichtung zum Anschluß externer Leitungen mit äquidistant nebeneinander angeordneten Steckplätzen (11 ... 18) und mit Steckbaugruppen, die eine Signalanpassungsschaltung für auf den externen Leitungen geführte Signale enthalten,
**dadurch gekennzeichnet,**
- daß je Steckplatz zwei Signalkanäle vorgesehen sind, deren Anschlußelemente (1 ... 10) in Zählrichtung der Steckplätze im halben Steckplatzraster nebeneinander angeordnet sind, wobei der Abstand der Anschlußelemente benachbarter Kanäle größer ist als die geforderte Mindestkriechstrecke für Ströme bei einer niedrigen von mehreren möglichen Betriebsspannungen und kleiner als die geforderte Mindestkriechstrecke bei einer höheren der möglichen Betriebsspannungen und wobei der Abstand der Anschlußelemente zweier Kanäle, zwischen denen Anschlußelemente eines anderen Kanals liegen, größer ist als die geforderte Mindestkriechstrecke für Ströme bei der höheren Betriebsspannung,
- daß codierte Steckbaugruppen mit einer höheren Betriebsspannung eine Signalanpassungsschaltung für einen Kanal enthalten, dessen Anschlußelemente auf der einen Seite liegen und einen Fortsatz (28) auf der einen Seite und eine zu einem entsprechenden Fortsatz einer benachbarten codierten Steckbaugruppe korrespondierende Ausnehmung (29) auf der anderen Seite aufweisen, so daß sie beliebig nebeneinander in die Steckplätze einsteckbar sind, und
- daß uncodierte Steckbaugruppen mit einer niedrigen Betriebsspannung eine Signalanpassungsschaltung für beide Signalkanäle enthalten und keine derartige Ausnehmung (29) aufweisen, so daß sie auf der einen Seite einer codierten Steckbaugruppe nicht in einen unmittelbar danebenliegenden Steckplatz einsteckbar sind.

## Claims

1. Device for coding plug-in modules, which are provided for assembly in a carrier unit having plug-in stations arranged equidistantly next to each other, characterised
- in that coded plug-in modules have an extension (28) on the one side and a recess (29) corresponding to a corresponding extension of an adjacent coded plug-in module on the other side, so that they can be plugged into the plug-in stations (11 ... 18) next to each other as desired, and
- in that uncoded plug-in modules do not have such a recess, so that on the one side of a coded plug-in module, they cannot be plugged into a directly adjacent plug-in station.

2. Device according to claim 1, characterised
- in that the modules for plugging in at the plug-in stations (11 ... 18) are pivotable about a swivel joint and
- in that the extension (28) and recess (29) of coded plug-in modules are located in the region of the swivel joint, so that the insertion of an uncoded plug-in module into the swivel joint is, if appropriate, already prevented by an extension.

3. Device for connecting external lines having plug-in stations (11 ... 18) arranged equidistantly next to each other and having plug-in modules which contain a signal conditioning circuit for signals carried on the external lines, characterised
- in that two signal channels are provided per plug-in station, the connection elements (1 ... 10) of which channels are arranged next to each other at half the plug-in station grid in the counting direction of the plug-in stations, the distance between the connection elements of adjacent channels being greater than the required minimum creepage distance for currents in the case of a low operating voltage out of several possible operating voltages, and smaller than the required minimum creepage distance in the case of a higher one of the possible operating voltages, and the distance between the connection elements of two channels, between which lie connection elements of another channel, being greater than the required minimum creepage distance for currents in the case of the higher operating voltage,
- in that coded plug-in modules with a higher operating voltage contain a signal conditioning circuit for a channel, the connection elements of which lie on the one side, and have an extension (28) on the one side and a recess (29) corresponding to a corresponding extension of an adjacent coded plug-in module on the other side, so that they can be plugged into the plug-in stations next to each other as desired, and
- in that uncoded plug-in modules with a low operating voltage contain a signal conditioning circuit for both signal channels and do not have such a recess (29), so that on the one side of a coded plug-in module, they cannot be plugged into a directly adjacent plug-in station.

## Revendications

1. Dispositif de codage de modules enfichables qui sont prévus pour un montage dans une unité de support à des emplacements d'enfichage disposés côte à côte de manière équidistante, caractérisé en ce que
- des modules d'enfichage codés comportent un prolongement (28) d'un côté et un évidement (29) de l'autre côté correspondant à un prolongement correspondant d'un module d'enfichage codé voisin, si bien qu'ils peuvent être enfichés de manière quelconque côte à côte dans les emplacements (11 ... 18) d'enfichage, et
- des modules d'enfichage non codés ne comportent pas d'évidements de ce genre, si bien qu'ils ne peuvent pas être enfichés d'un côté d'un module d'enfichage codé dans un emplacement d'enfichage se trouvant directement à côté.

2. Dispositif suivant la revendication 1, caractérisé en ce que
- les modules peuvent basculer par rapport à une articulation tournante en vue de l'enfichage dans les emplacements (11 ... 18) d'enfichage et
- un prolongement (28) et un évidement (29) de modules d'enfichage codés se trouvent dans la zone de l'articulation tournante, si bien qu'il est empêché par un prolongement éventuellement déjà l'introduction d'un module d'enfichage non codé dans l'articulation tournante.

3. Dispositif de raccordement de lignes externes comportant des emplacements (11 ... 18) d'enfichage montés côte à côte de manière équidistante et comportant des modules d'enfichage qui contiennent un circuit d'adaptation de signal pour des signaux guidés sur les lignes externes, caractérisé en ce que
- il est prévu pour chaque emplacement d'enfichage deux canaux de signalisation dont les éléments (1 ... 10) de raccordement sont disposés dans le sens de comptage des emplacement d'enfichage à la moitié de l'intervalle entre les emplacements d'enfichage, la distance des éléments de raccordement des canaux voisins étant plus grande que la ligne de fuite minimum exigée pour des courants à une basse tension de plusieurs tensions de fonctionnement possibles est plus petite que la ligne de fuite minimum exigée pour une assez grande tension des tensions de fonctionnement possibles et la distance entre les éléments de raccordement de deux canaux entre lesquels se trouvent des éléments de raccordement d'un autre canal étant plus grande que la ligne de fuite minimum exigée pour des courants à d'assez grandes tensions de fonctionnement,
- des modules d'enfichage codés ayant une tension de fonctionnement assez grande contiennent un circuit d'adaptation de signal pour un canal dont les éléments de raccordement se trouvent d'un côté et comportent un prolongement (28) de ce côté et un évidement (29) de l'autre côté correspondant à un prolongement correspondant d'un module d'enfichage codé voisin, si bien qu'ils peuvent être enfichés de manière quelconque côte à côte dans les emplacements d'enfichage, et
- des modules d'enfichage non codés ayant une tension de fonctionnement basse contiennent un circuit d'adaptation de signal pour les deux canaux de signalisation et ne comportent pas d'évidement (29) de ce genre, si bien qu'ils ne peuvent pas être enfichés d'un côté d'un module d'enfichage codé dans un emplacement d'enfichage qui se trouve directement à côté.
